(19) Europäisches Patentamt / European Patent Office / Office européen des brevets

(11) **EP 2 141 741 A2**

(12) **DEMANDE DE BREVET EUROPEEN**

(43) Date de publication:
**06.01.2010 Bulletin 2010/01**

(21) Numéro de dépôt: **09164596.0**

(22) Date de dépôt: **03.07.2009**

(51) Int Cl.:
*H01L 27/07* (2006.01)　　　*H01L 21/761* (2006.01)
*H01L 29/861* (2006.01)　　　*H01L 29/78* (2006.01)
*H02M 7/217* (2006.01)

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **04.07.2008 FR 0854555**

(71) Demandeurs:
- **STMicroelectronics (Rousset) SAS**
  **13790 Rousset (FR)**
- **Université de Provence (Aix-Marseille 1)**
  **13331 Marseille Cedex 3 (FR)**

(72) Inventeurs:
- **Battista, Marc**
  **13013 Marseille (FR)**
- **Chalopin, Hervé**
  **13400 Aubagne (FR)**
- **Barthelemy, Hervé**
  **83100 Toulon (FR)**

(74) Mandataire: **de Beaumont, Michel**
  **Cabinet Beaumont**
  **1, rue Champollion**
  **38000 Grenoble (FR)**

(54) **Circuit électronique comprenant un transistor MOS monté en diode à rendement amélioré**

(57) L'invention concerne un circuit intégré (40) comportant une couche semiconductrice (12) ; et un transistor MOS (M') comprenant des première et deuxième bornes de puissance (S, D) et un substrat (B) isolé de la couche semiconductrice, la première borne de puissance (D) étant destinée à recevoir un signal oscillant ($V_{IN}$), la grille (G) du transistor et le substrat étant reliés à la première borne de puissance.

Fig 6

EP 2 141 741 A2

**Description**

Domaine de l'invention

La présente invention concerne un circuit électronique comprenant un transistor MOSFET (de l'anglais Metal Oxide Semiconductor Field Effect Transistor) ou transistor MOS, monté en diode, dont l'une des bornes de puissance reçoit un signal oscillant, par exemple de signal alternatif.

Exposé de l'art antérieur

De nombreux circuits électroniques réalisent une fonction de conversion d'énergie. Le plus souvent, il s'agit d'une conversion d'un signal d'entrée alternatif, constitué d'une succession d'alternances positives et négatives, en un signal continu. L'un des circuits électroniques les plus simples pour réaliser cette fonction est le circuit redresseur simple alternance. Il est constitué d'un étage de redressement, suivi d'un étage de filtrage. L'étage de redressement peut comprendre une diode qui permet de conserver, par exemple, seulement les alternances positives du signal d'entrée. L'étage de filtrage peut comprendre un condensateur et fournit un signal sensiblement continu à partir des alternances positives.

Pour réaliser un circuit redresseur de façon intégrée selon une technologie CMOS, la diode est généralement remplacée par un transistor MOS, monté en diode, c'est-à-dire dont la grille est reliée au drain. L'essentiel des pertes énergétiques du circuit redresseur réalisé de façon intégrée proviennent du transistor lorsque celui-ci est passant et dépendent du produit entre le courant traversant le transistor et la tension drain-source du transistor. Lorsque le transistor est passant, le courant de canal du transistor varie en fonction de la tension grille-source, c'est-à-dire de la tension drain-source. Pour réduire les pertes du circuit redresseur, il faut que la tension drain-source reste la plus faible possible lorsque le transistor est passant. Il est donc souhaitable que la tension de seuil du transistor soit la plus faible possible.

De façon classique, le transistor MOS est réalisé dans et sur une couche d'un matériau semiconducteur polarisée par une source d'un potentiel de référence, par exemple la masse. Toutefois, avec une telle structure de transistor MOS, il s'avère difficile de diminuer de façon significative la tension de seuil du transistor. En outre, notamment lors des alternances négatives du signal d'entrée, on observe des pertes supplémentaires en raison du courant de fuite du transistor MOS à l'état bloqué et de la conduction de diodes parasites du transistor.

Résumé

La présente invention vise un circuit électronique comprenant un transistor MOS monté en diode dont l'une des bornes de puissance reçoit un signal oscillant, par exemple un signal alternatif, ayant des pertes réduites lorsque le transistor est passant.

Selon un autre objet, l'invention vise à réduire les pertes dues au courant de fuite du transistor lorsque le transistor est bloqué.

Selon un autre objet, la présente invention vise à réduire les pertes dues à la conduction de diodes parasites au cours de l'évolution du signal oscillant alors que le transistor est bloqué.

Ainsi, un mode de réalisation de la présente invention prévoit un circuit intégré comportant une couche semiconductrice ; et un transistor MOS comprenant des première et deuxième bornes de puissance et un substrat isolé de la couche semiconductrice, la première borne de puissance étant destinée à recevoir un signal oscillant, la grille du transistor et le substrat étant reliés à la première borne de puissance.

Selon un exemple de réalisation, le substrat correspond à une portion de la couche semiconductrice isolée du reste de la couche semiconductrice par une région dopée, la région dopée étant reliée à la deuxième borne de puissance.

Selon un exemple de réalisation, la région dopée est d'un premier type de conductivité, les première et deuxième bornes de puissance comprenant des régions dopées supplémentaires du premier type de conductivité, la couche semiconductrice étant non dopée ou dopée d'un second type de conductivité, ladite portion de la couche semiconductrice s'étendant au moins entre les régions dopées supplémentaires.

Selon un exemple de réalisation, le circuit comprend un filtre relié à la deuxième borne de puissance.

Selon un exemple de réalisation, le transistor MOS est un transistor MOS à canal N.

Un aspect de la présente invention vise un circuit électronique comprenant un circuit intégré tel que défini précédemment ; et une source d'un potentiel de référence reliée à la couche semiconductrice.

Selon un exemple de réalisation, le circuit électronique comprend, en outre, un premier condensateur comprenant une première armature reliée à la première borne de puissance ; un second condensateur comprenant une seconde armature reliée à la deuxième borne de puissance et une troisième armature reliée à la source du potentiel de référence ; et un transistor MOS supplémentaire, monté en diode, comprenant une troisième borne de puissance reliée à la première borne de puissance et une quatrième borne de puissance reliée à la source du potentiel de référence.

Selon un exemple de réalisation, le circuit électronique comprend, en outre, un premier condensateur comprenant une première armature reliée à la seconde borne de puissance et une deuxième armature ; un second condensateur comprenant une troisième armature reliée à la deuxième armature et une troisième armature reliée à la source du potentiel de référence ; et un transistor MOS supplémentaire, monté en diode, comprenant une troisième borne de puissance reliée à la première borne de puissance et une quatrième borne de puissance reliée à la source du potentiel de référence.

Selon un exemple de réalisation, le circuit électronique comprend, en outre, une source d'alimentation ; une inductance reliant la source d'alimentation à la première borne de puissance ; un transistor MOS supplémentaire comprenant une troisième borne de puissance reliée à la première borne de puissance et une quatrième borne de puissance reliée à la source du potentiel de référence ; une source d'une succession d'impulsions de tension à la grille du transistor MOS supplémentaire ; et un condensateur comprenant une première armature reliée à la deuxième borne de puissance et une deuxième armature reliée à la source du potentiel de référence.

Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :

la figure 1 représente de façon schématique un exemple classique d'un circuit redresseur ;
la figure 2 est une coupe schématique d'un transistor MOS classique monté en diode ;
la figure 3 représente, de façon schématique, un exemple de circuit redresseur mettant en oeuvre le transistor MOS monté en diode de la figure 2 ;
la figure 4 est une vue analogue à la figure 3, certaines diodes parasites du transistor MOS monté en diode ayant été représentées ;
la figure 5 représente un exemple de réalisation d'un transistor MOS monté en diode selon l'invention ;
la figure 6 représente un circuit redresseur muni du transistor MOS monté en diode de la figure 5 ;
la figure 7 représente des courbes d'évolution du courant de canal du transistor MOS monté en diode des circuits des figures 4 et 6 en fonction de la tension drain-source du transistor ;
la figure 8 représente des courbes d'évolution du courant de fuite du transistor MOS monté en diode des circuits des figures 4 et 6 en fonction de la tension d'entrée ;
la figure 9 représente des courbes d'évolution du courant au drain du transistor MOS monté en diode des circuits des figures 4 et 6 en fonction de la tension d'entrée ;
la figure 10 représente un autre exemple de réalisation d'un transistor MOS monté en diode selon l'invention ;
la figure 11 représente, de façon schématique, un exemple de circuit redresseur mettant en oeuvre le transistor MOS de la figure 10 ; et
les figures 12 à 14 représentent d'autres exemples de circuits munis du transistor MOS de la figure 4.

Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle. Dans la suite de la description, on appelle bornes de puissance d'un transistor MOS la source et le drain du transistor. En outre, dans la suite de la description, on considère un circuit recevant un signal oscillant. Un signal oscillant est un signal qui passe alternativement d'une valeur extrême haute à une valeur extrême basse. Les valeurs extrêmes haute et basse peuvent être de signes opposés. Le signal est alors dit alternatif. Il comprend alors successivement une alternance positive, une alternance négative, une alternance positive, une alternance négative, etc. Le signal oscillant peut être périodique.

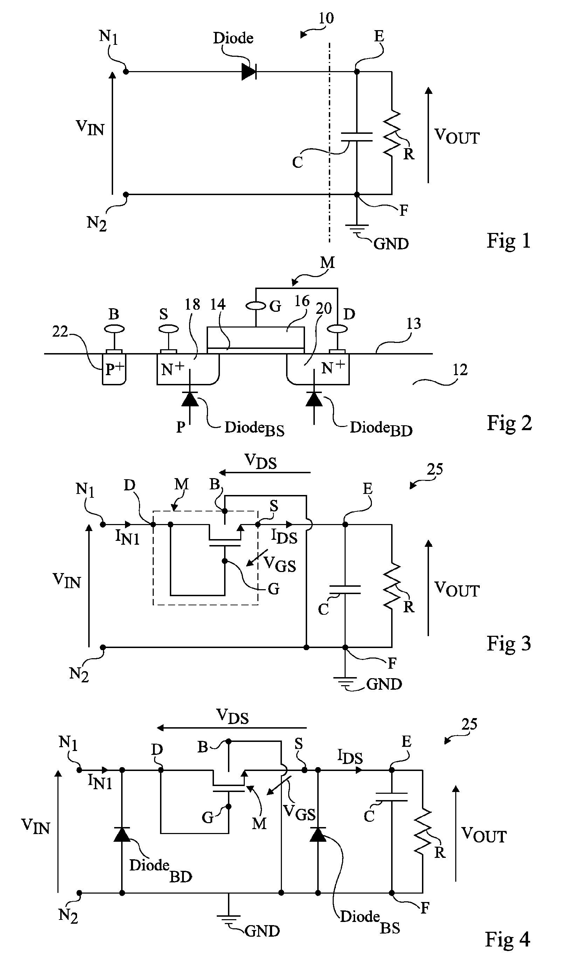

La figure 1 représente, de façon schématique, un circuit redresseur 10 simple alternance avec filtre à condensateur. Le circuit 10 comprend deux bornes d'entrée $N_1$ et $N_2$ entre lesquelles est appliquée une tension oscillante $V_{IN}$, par exemple une tension alternative. A titre d'exemple, la tension alternative $V_{IN}$ est une tension sinusoïdale. La tension $V_{IN}$ peut être fournie à partir d'un signal radiofréquence capté par une antenne. De façon générale, la tension alternative $V_{IN}$ est une tension périodique, comprenant, pour chaque période, une alternance positive et une alternance négative. La borne d'entrée $N_2$ est reliée à une source d'un potentiel de référence, par exemple la masse GND. Le circuit 10 comprend une diode Diode dont l'anode est reliée à la borne d'entrée $N_1$ et dont la cathode est reliée à un noeud E. Un condensateur C est disposé entre le noeud E et un noeud F relié à la masse GND. Une résistance R est disposée en parallèle aux bornes du condensateur C. On désigne par la référence $V_{OUT}$ la tension entre les noeuds E et F.

Lorsque le circuit redresseur 10 doit être réalisé de façon intégrée selon une technologie CMOS, la fonction remplie par la diode Diode du circuit 10, est réalisée par un transistor MOS, monté en diode.

La figure 2 représente un exemple d'une structure classique d'un transistor MOS M monté en diode formé au niveau d'une couche 12 d'un matériau semiconducteur, par exemple du silicium monocristallin dopé de type P, ayant une surface supérieure 13. A titre d'exemple, le transistor M est un transistor à canal N. Le transistor MOS comprend une portion isolante 14, par exemple en oxyde de silicium, recouvrant la couche 12. Une portion 16 d'un matériau semiconducteur, par exemple du silicium polycristallin, recouvre la portion isolante 14. Des régions dopées de type N 18, 20 sont prévues dans la couche 12 de part et d'autre de la portion isolante 14. Les régions 18 et 20 s'étendent éventuellement partiellement sous la portion isolante 14. Une région 22 dopée de type P s'étend dans la couche 12 depuis la surface 13. La région 22 est plus fortement dopée que la couche 12. La portion isolante 14 constitue l'isolant de grille du transistor M et la portion 16 constitue la grille du transistor M. La région 18 constitue la région de source du transistor M et la région 20 constitue la région de drain du transistor M.

Les connexions des éléments du transistor M sont réalisées par des pistes et vias conducteurs non représentés en détail. On a schématiquement représenté en figure 2 une borne G connectée à la portion 16, une borne S connectée à la région de source 18 et une borne D connectée à la région de drain. Une borne B est connectée à la région 22 et permet de polariser la couche 12. Dans la suite de la description, on appelle indifféremment grille du transistor M la portion 16 ou la borne G, source du transistor M la région 18 ou la borne S et drain du transistor M la région 20 ou la borne D. Le transistor M étant monté en diode, la grille G est reliée au drain D.

En figure 2, on a représenté deux diodes parasites intrinsèques au transistor M. Une première diode parasite $Diode_{BS}$ correspond à la jonction entre la couche 12 et la région de source 18. Une seconde diode parasite $Diode_{BD}$ correspond à la jonction entre la couche 12 et la région de drain 20.

La figure 3 représente un circuit redresseur 25 analogue au circuit 10 de la figure 1 dans lequel la fonction remplie par la diode Diode est réalisée à partir du transistor M monté en diode de la figure 2. Le drain D du transistor M est relié à la borne d'entrée $N_1$. La source S du transistor M est reliée au noeud E. Le substrat B du transistor M est polarisé à la masse GND. Dans la suite de la description, on appelle $V_{DS}$ la tension entre le drain D et la source S du transistor M, $V_{GS}$ la tension entre la grille G et la source S du transistor M et $I_{N1}$ est le courant à la borne d'entrée $N_1$. Le circuit redresseur 25 est destiné à être connecté à d'autres circuits au niveau des noeuds E et F.

La tension de seuil $V_{t0}$ du transistor M du circuit 10 est donnée par la relation suivante :

$$V_{t0} \;=\; C_1 \;+\; C_2 \;*\; \sqrt{(C_3 \;+\; V_{OUT})} \tag{1}$$

où $C_1$, $C_2$ et $C_3$ sont des constantes. En raison du filtrage réalisé par le condensateur C et la résistance R, la tension $V_{OUT}$ varie peu de sorte que la tension de seuil $V_{t0}$ peut être considéré comme sensiblement constante.

Les pertes du circuit 25 dues à la conduction du transistor M sont proportionnelles au produit de la tension $V_{DS}$, égale à la tension $V_{GS}$, et du courant $I_{DS}$. Ces pertes se produisent, en régime établi, lorsque la tension $V_{GS}$ est supérieure à la tension de seuil $V_{t0}$. Pour minimiser les pertes dues à la conduction du transistor M, il est souhaitable que la tension de seuil $V_{t0}$ du transistor M soit la plus faible possible. La relation (1) montre que la tension de seuil $V_{t0}$ est directement imposée par la valeur de la tension $V_{OUT}$ qui est généralement fixée par l'application envisagée du circuit redresseur 25. Il s'avère donc difficile de réduire la tension de seuil $V_{t0}$. En outre, le transistor M présente un courant de fuite à l'état bloqué, notamment lors des alternances négatives de la tension $V_{IN}$, qui augmente les pertes du circuit 25. De façon générale, plus la tension de seuil d'un transistor MOS est faible, plus le courant de fuite est important. Il n'est donc pas possible avec le circuit 25 de réduire simultanément la tension de seuil $V_{t0}$ et le courant de fuite du transistor MOS.

La figure 4 représente le circuit redresseur 25 de la figure 3 dans lequel les diodes parasites $Diode_{BS}$ et $Diode_{BD}$ du transistor M ont été représentées. La diode parasite $Diode_{BD}$ s'étend entre les bornes $N_1$ et $N_2$, l'anode de la diode $Diode_{BD}$ étant connectée à la borne d'entrée $N_2$. La diode parasite $Diode_{BS}$ s'étend entre les noeuds E et F, l'anode de la diode $Diode_{BS}$ étant connectée au noeud F. Sur chaque alternance négative de la tension $V_{IN}$, la diode parasite $Diode_{BD}$ peut devenir passante. Ceci augmente les pertes du circuit 25. Lorsque la diode parasite $Diode_{BD}$ est bloquée, l'impédance d'entrée du circuit 25 est élevée. Toutefois, lorsque la diode parasite $Diode_{BD}$ devient passante, l'impédance d'entrée du circuit 25 chute, ce qui peut être pénalisant pour certaines applications. Il peut donc être nécessaire de limiter l'amplitude de la tension $V_{IN}$ pour éviter la chute de l'impédance d'entrée du circuit 25.

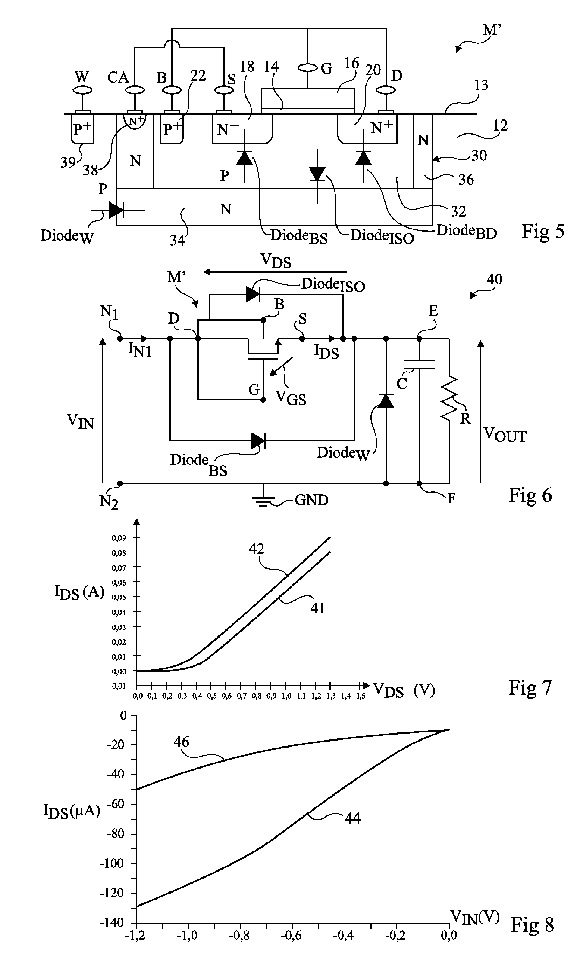

La figure 5 représente la structure d'un transistor M' monté en diode selon un exemple de réalisation de l'invention. Par rapport au transistor M représenté en figure 2, le transistor M' comprend une structure 30 d'isolement de substrat qui délimite une partie 32 de la couche semiconductrice 12 autour des régions de source et de drain 18, 20 du transistor M'. La portion 32, électriquement isolée du reste de la couche 12, est appelée substrat 32 (en anglais bulk ou body) du transistor M' dans la suite de la description. Le dopage de la région 32 est choisi suffisamment faible pour que la tension de seuil du transistor MOS soit nettement inférieure à 0,6 V, de préférence comprise entre 0,1 et 0,3 V. La structure 30 d'isolement de substrat comprend une région enterrée 34 de type N située en profondeur dans la couche 12 et s'étendant sous les régions 18, 20 et 22. La structure 30 d'isolement de substrat comprend, en outre, une paroi latérale 36 correspondant à une région de type N s'étendant depuis la surface 13 de la couche 12 jusqu'à la région enterrée 34 et entourant les régions 18, 20 et 22. Une région 38, de type N, plus fortement dopée que la région 36 s'étend dans la région 36 depuis la surface 13. Une borne de polarisation CA de la structure 30 d'isolement de substrat est connectée à la région 38. Une région 39 dopée de type P s'étend dans la couche 12 depuis la surface 13 à l'extérieur de la structure 30 d'isolement de substrat. Une borne W est connectée à la région 39 et permet de polariser le reste de la couche 12. Le transistor M' étant monté en diode, la grille G est reliée au drain D. En outre, la borne B de polarisation du substrat 32 est reliée au drain D et la borne CA de polarisation de la structure 30 d'isolement de substrat est reliée à la source S. La borne W de polarisation de la couche 12 est reliée à la source du potentiel de référence GND.

En figure 5, on a représenté schématiquement les diodes parasites intrinsèques du transistor M'. La diode $Diode_{BS}$ correspond à la jonction entre le substrat 32 du transistor M' et la région de source 18. La diode $Diode_{BD}$ correspond à la jonction entre le substrat 32 du transistor M' et la région de drain 20. La diode $Diode_W$ correspond à la jonction entre la structure 30 d'isolement de substrat et la partie de la couche 12 à l'extérieur de la structure 30 d'isolement de substrat. La diode $Diode_{ISO}$ correspond à la jonction entre le substrat 32 du transistor M' et la structure 30 d'isolement de substrat.

La figure 6 représente un circuit redresseur 40 analogue au circuit redresseur 25 de la figure 3 dans lequel le transistor M' est utilisé. Les diodes parasites $Diode_{ISO}$, $Diode_{BS}$ et $Diode_W$ du transistor M' sont représentées. Les diodes $Diode_{ISO}$ et $Diode_{BS}$ s'étendent entre le drain D et le noeud E, les anodes des diodes $Diode_{ISO}$ et $Diode_{BS}$ étant reliées au drain D. La diode $Diode_W$ s'étend entre les noeuds E et F, l'anode de la diode $Diode_W$ étant reliée au noeud F. Le substrat B étant relié au drain D du transistor M', la jonction entre le substrat 32 et la région de drain 20 est court-circuitée de sorte que la diode parasite $Diode_{BS}$ n'intervient pas.

La demanderesse a mis en évidence que pour le transistor M' connecté comme cela est représenté en figure 6, la tension de seuil $V_{t1}$ du transistor M' est donnée par la relation suivante :

$$V_{t1}(t) = C_1 + C_2 * \sqrt{(C_3 - V_{GS}(t))} \qquad (2)$$

La tension de seuil $V_{t1}$ varie donc en fonction de la tension $V_{GS}$, c'est-à-dire en fonction de la tension $V_{DS}$. En particulier $V_{t1}$ diminue lorsque que la tension $V_{GS}$ est positive et croît. La tension de seuil $V_{t1}$ pour laquelle le transistor M' devient passant lors d'une alternance positive de la tension $V_{IN}$ est inférieure à la tension de seuil $V_{t0}$ définie par la relation (1). Cette tension de seuil du transistor MOS est en tout cas nettement inférieure à la tension de conduction en direct d'une diode bipolaire (environ 0,6 V).

La figure 7 représente des courbes 41, 42 d'évolution du courant $I_{DS}$ en fonction de la tension $V_{DS}$. La courbe 41 correspond au circuit 25 de la figure 4 pour $V_{OUT}$ égal à 1 V et la courbe 42 correspond au circuit 40 de la figure 6. La tension de seuil $V_{t1}$ du transistor M' selon le présent exemple de réalisation de l'invention étant plus faible que la tension de seuil $V_{t0}$ du transistor M, pour un même courant $I_{DS}$, la tension $V_{DS}$ du circuit de la figure 6 est inférieure à celle du circuit de la figure 4. Les pertes en conduction du circuit 40 sont ainsi diminuées par rapport au circuit 25. En outre, les diodes parasites $Diode_{ISO}$ et $Diode_{BS}$ du transistor M' ne peuvent pas devenir passantes.

La figure 8 représente des courbes d'évolution 44, 46 du courant de fuite respectivement des transistors M et M' lors d'une alternance négative de la tension $V_{IN}$.

Pour le circuit 25 de la figure 4, la tension de seuil $V_{t0}$ du transistor M ne varie sensiblement pas pendant une alternance négative de la tension $V_{IN}$ (relation (1)). Tout au long de l'alternance négative, la tension $V_{GS}$ est négative et supérieure, en valeur absolue, à $V_{OUT}$. La tension $V_{t1}$ est donc supérieure à la tension de seuil $V_{t0}$ tout au long de l'alternance négative. Le courant de fuite d'un transistor MOS diminuant lorsque la tension de seuil du transistor augmente, le courant de fuite du transistor M' est inférieur au courant de fuite du transistor M d'au moins un facteur 2 sur la majeure partie de l'alternance négative.

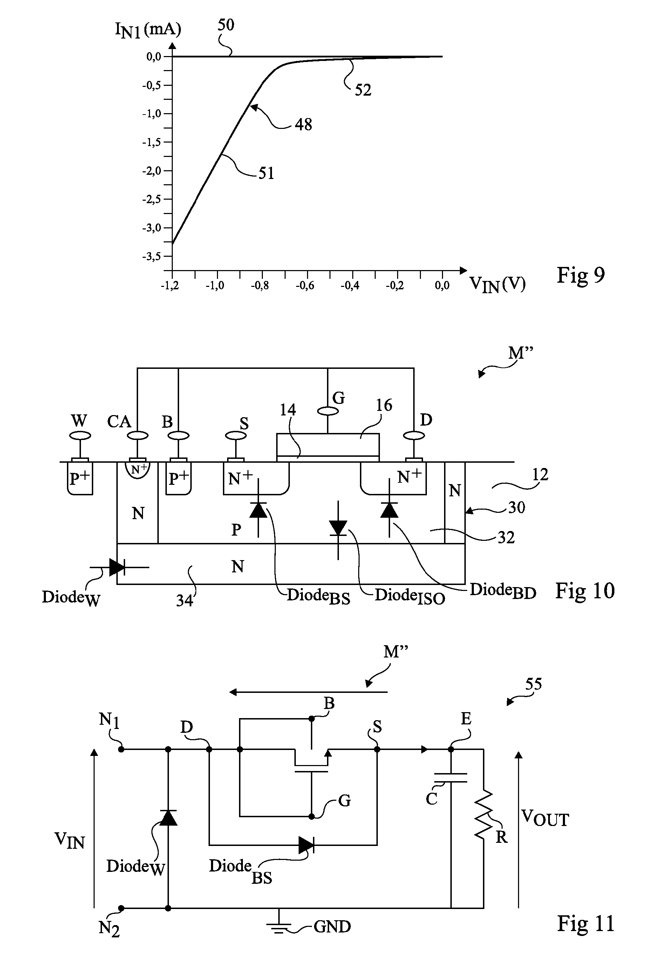

La figure 9 représente des courbes 48, 50 d'évolution du courant $I_{N1}$ à la borne d'entrée $N_1$ en fonction de la tension $V_{IN}$ lors d'une alternance négative de la tension $V_{IN}$. La courbe 48 correspond au circuit 25 de la figure 4 et la courbe 50 correspond au circuit 40 de la figure 6. La courbe 48 comprend une première partie 51 fortement croissante suivie d'une seconde partie 52 très faiblement croissante. La courbe 50 ne comprend qu'une partie très faiblement croissante. Pour le circuit 25, au cours de l'alternance négative, la diode parasite $Diode_{BD}$ tend à être passante ce qui se traduit par un courant $I_{N1}$ négatif qui augmente fortement, en valeur absolue, lorsque la tension $V_{IN}$ négative augmente, en valeur absolue (partie 51 de la courbe 48). Lorsque la diode parasite $Diode_{BD}$ n'est plus passante, le courant $I_{N1}$ correspond au courant de fuite du transistor M pendant l'alternance négative (partie 52 de la courbe 48). Pour le circuit 40, il n'y a plus de diode parasite entre les bornes d'entrée $N_1$ et $N_2$. La courbe 50 traduit bien le fait que le courant $I_D$ est seulement égal au courant de fuite du transistor M' tout au long de l'alternance négative qui est inférieur au courant de fuite du transistor M. Les pertes supplémentaires lors d'une alternance négative de la tension $V_{IN}$ sont donc diminuées pour le circuit 40 par rapport au circuit 25. En outre, l'absence de diode parasite pour le transistor M' entre les bornes d'entrée $N_1$ et $N_2$ fait qu'il n'y a plus de risque de chute de l'impédance d'entrée du circuit 40. De ce fait, il n'y a plus de contraintes concernant l'amplitude de la tension $V_{IN}$ lors de l'alternance négative et il n'y a pas de risque de perte de modulation.

La figure 10 représente un autre exemple d'une structure de transistor MOS M" monté en diode selon l'invention. La structure du transistor M" est semblable à celle du transistor M' de la figure 5 à la différence que la borne CA est connectée au drain D et non à la source S. La borne W est, comme pour le transistor M', reliée à la masse GND. L'expression de la tension de seuil du transistor M" est donnée par la relation (2). On retrouve les mêmes avantages concernant la diminution de la tension seuil que pour l'exemple de réalisation décrit précédemment en relation avec la figure 5.

La figure 11 représente un circuit 55 analogue au circuit 40 de la figure 6 à la différence que le transistor M' est remplacé par le transistor M". La diode parasite $Diode_W$ est alors située entre les bornes d'entrée $N_1$ et $N_2$. On retrouve alors les inconvénients du circuit 10 de la figure 4 avec des pertes dues à la conduction de la diode parasite $Diode_W$ au cours des alternances négatives de la tension $V_{1N}$.

Bien que le transistor MOS M' selon le présent exemple de réalisation de l'invention ait été décrit pour un circuit redresseur 40, le transistor M' ou M" peut être utilisé pour d'autres types de circuits électroniques mettant en oeuvre un transistor MOS monté en diode dont le drain reçoit un signal oscillant.

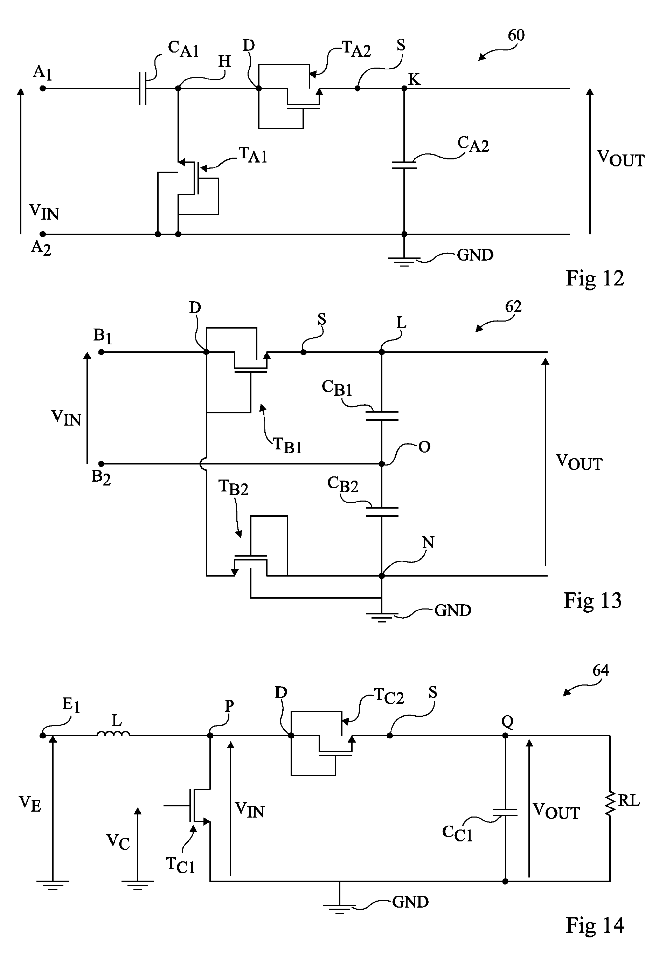

Les figures 12 à 14 représentent d'autres exemples de circuits électroniques dans lesquels le transistor MOS M' ou M" selon les exemples de réalisation de l'invention décrits précédemment peut être utilisé.

La figure 12 représente un exemple de circuit 60 récupérateur d'énergie à pompes de charge. Le circuit 60 comprend des bornes d'entrée $A_1$ et $A_2$ recevant la tension alternative $V_{1N}$. La borne $A_2$ est reliée à la masse GND. La borne $A_1$ est connectée à une armature d'un condensateur $C_{A1}$ dont l'autre armature est reliée à un noeud H. Un transistor $T_{A1}$ monté en diode est prévu entre le noeud H et la borne d'entrée $A_2$. Le substrat, la grille et la source du transistor $T_{A1}$ sont reliés à la masse GND. Le transistor $T_{A1}$ peut avoir la structure du transistor M de la figure 2. Un transistor $T_{A2}$, monté en diode, est disposé entre le noeud H et un noeud K. Le transistor $T_{A2}$ correspond au transistor M' ou M" selon les exemples de réalisation de l'invention décrits précédemment. Le substrat, la grille et le drain du transistor $T_{A2}$ sont reliés au noeud H. La borne CA, non représentée, et la source du transistor $T_{A1}$ sont reliées au noeud K. Un condensateur $C_{A2}$ est prévu entre le noeud K est la masse GND. La tension $V_{OUT}$ correspond à la tension entre le noeud K et la masse GND.

La figure 13 représente un exemple de circuit 62 de récupération d'énergie à entrée différentielle. Le circuit 62 comprend des bornes d'entrée $B_1$ et $B_2$ recevant la tension alternative $V_{1N}$. Un transistor $T_{B1}$ monté en diode est prévu entre la borne d'entrée $B_2$ et un noeud L. Le transistor $T_{B1}$ correspond au transistor M' ou M" selon les exemples de réalisation de l'invention décrits précédemment. Le substrat, la grille et le drain du transistor $T_{B1}$ sont reliés à la borne $B_1$. La borne CA, non représentée, et la source du transistor $T_{A1}$ sont reliées au noeud L. Un condensateur $C_{B1}$ est disposé entre le noeud L et un noeud O relié à la borne d'entrée $B_2$. Un condensateur $C_{B2}$ est disposé entre le noeud O et un noeud N. Le noeud N est relié à la masse GND. Un transistor $T_{B2}$ monté en diode est prévu entre la borne d'entrée $B_1$ et le noeud N. Le substrat, la grille et le drain du transistor $T_{B2}$ sont reliés à la masse GND. Le transistor $T_{B2}$ peut avoir la structure du transistor M de la figure 2. La tension $V_{OUT}$ est prise entre les noeuds L et N.

La figure 14 représente un exemple de circuit 64 hacheur élévateur. Le circuit 64 comprend une borne d'entrée $E_1$ recevant une tension $V_E$, par exemple, une tension continue. La borne $E_1$ est reliée à un noeud P par une inductance L. Un transistor $T_{C1}$ est prévu entre le noeud P et la masse GND. La grille du transistor $T_{C1}$ reçoit une succession d'impulsions de tension $V_C$ dont la fréquence dépend de la tension $V_{OUT}$ désirée. La tension $V_{1N}$ oscillante est la tension entre le noeud P et la masse GND. Un transistor $T_{C2}$, monté en diode, est disposé entre le noeud P et un noeud Q. Le transistor $T_{C2}$ correspond au transistor M' ou M" selon les exemples de réalisation de l'invention décrits précédemment. Le substrat, la grille et le drain du transistor $T_{C2}$ sont reliés au noeud P. La borne CA, non représentée, et la source du transistor $T_{C2}$ sont reliées au noeud Q. Un condensateur $C_{C1}$ est disposé entre le noeud Q et la masse GND. Une résistance RL est prévue aux bornes du condensateur $C_{C1}$. La tension $V_{OUT}$ correspond à la tension aux bornes du condensateur $C_{C1}$. Le fonctionnement du circuit 64 au cours d'un cycle de commande du transistor $T_{C1}$ est schématiquement le suivant. Lorsque le transistor $T_{C1}$ est passant, la tension $V_{IN}$ est sensiblement nulle. Le transistor $T_{C2}$ est alors bloqué. Au moment où le transistor $T_{C1}$ passe de l'état passant à l'état bloqué, la tension $V_{IN}$ s'élève fortement de façon temporaire en raison de l'inductance L. Le transistor $T_{C2}$ devient passant entraînant la charge du condensateur C. La tension $V_{IN}$ diminue alors jusqu'à $V_E$ entraînant le blocage du transistor $T_{C2}$.

Des modes de réalisation particuliers de la présente invention ont été décrits. Diverses variantes et modifications apparaîtront à l'homme de l'art. En particulier, bien que les exemples de réalisation décrits précédemment concernent un transistor MOS à canal N, la présente invention s'applique également à un transistor MOS à canal P. Dans ce cas, le transistor MOS est, par exemple, réalisé dans un caisson de type N prévu au niveau d'une couche dopée de type P. Le caisson de type N forme le substrat du transistor. Des régions dopées de type P sont prévues dans le caisson de type N et forment les régions de source et de drain du transistor MOS. La grille et le substrat sont reliés au drain du transistor.

**Revendications**

1. Circuit intégré (40 ; 60 ; 62 ; 64) comportant :

une couche semiconductrice (12) ; et
un transistor MOS (M' ; M" ; $T_{A2}$ ; $T_{B1}$ ; $T_{C2}$) comprenant des première et deuxième bornes de puissance (S, D) et un substrat (B) isolé de la couche semiconductrice, la première borne de puissance (D) étant destinée à recevoir un signal oscillant ($V_{1N}$), la grille (G) du transistor et le substrat étant reliés à la première borne de puissance, ledit transistor MOS étant conçu pour que sa tension de seuil soit inférieure à 0,6 V, de préférence comprise entre 0,1 et 0,3 V.

2. Circuit intégré selon la revendication 1, dans lequel le substrat (B) correspond à une portion (32) de la couche semiconductrice (12) isolée du reste de la couche semiconductrice par une région dopée (30), la région dopée étant reliée à la deuxième borne de puissance (S).

3. Circuit intégré selon la revendication 2, dans lequel la région dopée (30) est d'un premier type de conductivité, les première et deuxième bornes de puissance (S, D) comprenant des régions dopées supplémentaires (18, 20) du premier type de conductivité, la couche semiconductrice (12) étant non dopée ou dopée d'un second type de conductivité, ladite portion (32) de la couche semiconductrice s'étendant au moins entre les régions dopées supplémentaires.

4. Circuit intégré selon l'une quelconque des revendications 1 à 3, comprenant un filtre (R, C) relié à la deuxième borne de puissance (S).

5. Circuit intégré selon l'une quelconque des revendications 1 à 4, dans lequel le transistor MOS (M' ; M" ; $T_{A2}$ ; $T_{B1}$ ; $T_{C2}$) est un transistor MOS à canal N.

6. Circuit électronique (40 ; 60 ; 62 ; 64) comprenant :

un circuit intégré selon l'une quelconque des revendications 1 à 5 ; et
une source d'un potentiel de référence (GND) reliée à la couche semiconductrice (12).

7. Circuit électronique (60) selon la revendication 6, comprenant, en outre :

un premier condensateur ($C_{A1}$) comprenant une première armature reliée à la première borne de puissance (D) ;
un second condensateur ($C_{A2}$) comprenant une seconde armature reliée à la deuxième borne de puissance (S) et une troisième armature reliée à la source du potentiel de référence (GND) ; et
un transistor MOS supplémentaire ($T_{A1}$), monté en diode, comprenant une troisième borne de puissance reliée à la première borne de puissance et une quatrième borne de puissance reliée à la source du potentiel de référence.

8. Circuit électronique (62) selon la revendication 6, comprenant, en outre :

un premier condensateur ($C_{B1}$) comprenant une première armature reliée à la seconde borne de puissance (S) et une deuxième armature ;
un second condensateur ($C_{B2}$) comprenant une troisième armature reliée à la deuxième armature et une troisième armature reliée à la source du potentiel de référence (GND) ; et
un transistor MOS supplémentaire ($T_{B2}$), monté en diode, comprenant une troisième borne de puissance reliée à la première borne de puissance et une quatrième borne de puissance reliée à la source du potentiel de référence.

9. Circuit électronique (64) selon la revendication 6, comprenant, en outre :

une source d'alimentation ($V_E$) ;
une inductance (L) reliant la source d'alimentation à la première borne de puissance (D) ;

un transistor MOS supplémentaire ($T_{C1}$) comprenant une troisième borne de puissance reliée à la première borne de puissance et une quatrième borne de puissance reliée à la source du potentiel de référence (GND) ; une source d'une succession d'impulsions de tension ($V_C$) à la grille du transistor MOS supplémentaire ; et un condensateur ($C_{C1}$) comprenant une première armature reliée à la deuxième borne de puissance (S) et une deuxième armature reliée à la source du potentiel de référence.

Fig 1

Fig 2

Fig 3

Fig 4

Fig 5

Fig 6

Fig 7

Fig 8

Fig 9

Fig 10

Fig 11

Fig 12

Fig 13

Fig 14